# EUROPEAN PATENT APPLICATION

(11) **EP 4 675 109 A1**
(43) Date of publication of application: **07.01.2026**
(21) Application number: 24901776.5
(22) Date of filing: 26.09.2024
(51) Int. Cl.: F04D 25/08

(54) **FAN ROTOR, COOLING FAN AND ELECTRONIC DEVICE**

(30) Priority: 21.05.2024 CN 202421116195 U
(71) Applicant: Nanchang Huaqin Electronic Technology Co., Ltd., Nanchang, Jiangxi 330224 (CN)
(72) Inventor: YANG, Jialiang, Nanchang, Jiangxi 330224 (CN); LI, Chuansheng, Nanchang, Jiangxi 330224 (CN); YU, Binjun, Nanchang, Jiangxi 330224 (CN)
(74) Representative: Boult Wade Tennant LLP
(86) International application number: PCT/CN2024/121261
(87) International publication number: WO 2025/241368

(57) **Abstract**

Disclosed are a fan rotor, a cooling fan and an electronic device. The fan rotor includes a central shaft, a plurality of first blades, a plurality of second blades, a first fixing ring, and a second fixing ring. The plurality of first blades are arranged around the central shaft, with first ends connected to the central shaft. The plurality of second blades are arranged around the central shaft, and located at a periphery of the plurality of first blades. The first fixing ring is configured to fix first ends of the plurality of second blades, and arranged around the central shaft. The second fixing ring is configured to fix second ends of the plurality of second blades, and arranged around the first fixing ring. The fan rotor, the cooling fan and the electronic device provided in the embodiments of the present application can ensure stability of the cooling fan in operation.

## Description

The present application claims priority from Chinese patent application No. 202421116195.1, titled "FAN ROTOR, COOLING FAN AND ELECTRONIC DEVICE" filed with the China Patent Office on May 21, 2024, the entire contents of which are incorporated herein by reference.

### TECHNICAL FIELD

Embodiments of the present application relate to the technical field of electronic device heat dissipation, and in particular relate to a fan rotor, a cooling fan and an electronic device.

### BACKGROUND OF THE INVENTION

With the continuous miniaturization development tendency of electronic devices, the problem of heat accumulation in the electronic device is becoming more and more severe. In the working process of the electronic device, the continuously accumulated heat may influence normal operation of some components, and further suppressing better performance of the electronic device. Therefore, some heat dissipation means is desired for dissipating the heat generated by heat-producing components in the electronic device.

At present, air-cooled heat dissipation is still a widely applied heat dissipation form. In air-cooled heat dissipation, a cooling fan is used, which can increase the air circulation rate during operation, and timely transfer heat from a specific region to the outside. The stability of the cooling fan during operation will affect the heat dissipation capability of the cooling fan. Therefore, how to ensure the stability of the cooling fan during operation is an important issue.

### SUMMARY OF THE INVENTION

An object of the implementations of the present application is to provide a fan rotor, a cooling fan and an electronic device which can ensure stability of the cooling fan in operation.

To solve the above technical problem, an implementation of the present application provides a fan rotor. The fan rotor includes a central shaft, a plurality of first blades, a plurality of second blades, a first fixing ring, and a second fixing ring. The plurality of first blades are arranged around the central shaft, with first ends connected to the central shaft. The plurality of second blades are arranged around the central shaft, and located at a periphery of the plurality of first blades. The first fixing ring is configured to fix first ends of the plurality of second blades, and arranged around the central shaft. The second fixing ring is configured to fix second ends of the plurality of second blades, and arranged around the first fixing ring.

An implementation of the present application further provides a cooling fan, including a housing, a fan stator, and the fan rotor as described above. The fan stator is disposed in the housing, and the fan rotor is rotatably connected to the fan stator.

An implementation of the present application further provides an electronic device, including the cooling fan as described above.

According to the fan rotor, the cooling fan and the electronic device provided in the implementations of the present application, when the second blades are arranged at a periphery of the first blades, fixing rings may be provided at two ends of the second blades, respectively. In other words, the plurality of second blades are connected at roots by the first fixing ring, and connected at tips by the second fixing ring. The first blades are directly connected to the periphery of the central shaft. With the fixing rings at both ends of the blades on an outer ring, the connection areas of the blades are increased, and the two types of blades are connected into a whole. By arranging the plurality of fixing rings, the connection stability between outer ring blades and between outer and inner ring blades can be improved, thereby ensuring stability of the cooling fan in operation.

In some implementations, some of the plurality of second blades are provided with extension parts at the first ends, and each extension part passes through a gap between two adjacent first blades to be connected to the central shaft. In this manner, the first ends of some second blades are connected to the central shaft through the extension parts, so that the stability of the two types of blades when connected into a whole can be improved.

In some implementations, the extension parts in the same gap are connected with each other. In this manner, by connecting the extension parts in the same gap with each other, a connection relationship can be established between the extension parts, which can help to improve the connection stability between the extension parts and the central shaft.

In some implementations, a reinforcing part is provided between two adjacent extension parts connected to the central shaft, and extends from a surface of the first fixing ring to the central shaft. In this manner, the connection strength between two adjacent extension parts can be enhanced by providing the reinforcing part between two adjacent extension parts.

In some implementations, the first fixing ring is connected to the plurality of second blades at edges of the second blades in an axial direction of the central shaft, and/or the second fixing ring is connected to the plurality of second blades at edges of the second blades in the axial direction of the central shaft. In this manner, by connecting the fixing rings to the edges of the second blades, the connection structure between the fixing rings and the second blades can be simplified, thereby facilitating the connection.

In some implementations, the first fixing ring is connected to the plurality of second blades at middle parts of the second blades in an axial direction of the central shaft, and/or the second fixing ring is connected to the plurality of second blades at middle parts of the second blades in the axial direction of the central shaft. In this manner, by connecting the fixing rings to the middle parts of the second blades, the connection areas between the fixing rings and the second blades, as well as the connection strength, can be increased.

In some implementations, the plurality of first blades are axial flow blades, and the plurality of second blades are centrifugal blades. In this manner, when the outer ring centrifugal blades form an air flow in a radial direction, the inner ring axial flow blades can form an air flow in the axial direction, thereby increasing the air inlet volume.

In some implementations, in an axial direction of the central shaft, surfaces of the first blades do not protrude from surfaces of the second blades. In this manner, by providing surfaces of the first blades not protruding from surfaces of the second blades, the first blades are prevented from occupying more space.

### BRIEF DESCRIPTION OF THE DRAWINGS

One or more embodiments are illustrated through corresponding figures in the accompanying drawings, but such illustration does not constitute any limitation to the embodiments. Throughout the drawings, elements having like reference numerals represent like elements, and the drawings are not to be construed as limiting in scale unless otherwise specified.
FIG. 1 is a schematic perspective view of a fan rotor for a cooling fan according to some embodiments of the present application;
FIG. 2 is a schematic perspective view of a fan rotor for a cooling fan according to some other embodiments of the present application;
FIG. 3 is a schematic top view of a fan rotor for a cooling fan according to still other embodiments of the present application;
FIG. 4 is a schematic perspective view of a fan rotor for a cooling fan according to still other embodiments of the present application;
FIG. 5 is a schematic perspective view of a fan rotor for a cooling fan according to still other embodiments of the present application;
FIG. 6 is a schematic enlarged structural view at A in FIG. 5;
FIG. 7 is a schematic perspective view of a fan rotor for a cooling fan according to still other embodiments of the present application;
FIG. 8 is a schematic enlarged structural view at B in FIG. 7;
FIG. 9 is a schematic perspective view of an axial flow fan in the existing art; and
FIG. 10 is a schematic perspective view of a centrifugal fan in the existing art.

### DETAIL DESCRIPTION OF THE INVENTION

To make the objects, technical solutions and advantages of the embodiments of the present application clearer, implementations of the present application will be described in detail below with reference to the accompanying drawings. However, it will be appreciated by those of ordinary skill in the art that numerous technical details are set forth in various implementations of the present application to provide a better understanding of the present application. However, the technical solutions claimed in the present application can be implemented even without these technical details or based on various changes and modifications based on the following implementations. The following embodiments are divided for convenience of description, and should not constitute any limitation to the specific implementation of the present application, and the embodiments may be mutually incorporated and referred to without contradiction.

Unless otherwise defined, all technical and scientific terms used herein have the same meaning as commonly understood by one of ordinary skill in the art of the present application. The terminology used herein is for the purpose of describing particular embodiments only and is not intended to be limiting of the present application. The terms "include" and "comprise", as well as any variations thereof, used in the description and claims of the present application and the description of the figures above, are intended to cover a non-exclusive inclusion.

In the description of the embodiments of the present application, unless explicitly stated or defined otherwise, the terms "mounted", "connected", "coupled" and the like are to be construed broadly and encompass, for example, fixed connection, detachable connection, or integral connection; or mechanical or electrical connection; or directly connected, indirectly connected via an intermedium, or two elements in internal communication or interaction. The specific meaning of the above terms in the embodiments of the present application will be understood by those of ordinary skill in the art as the case may be.

With the continuous miniaturization tendency of electronic devices, the demand for heat dissipation is also increasing. For example, various heat dissipation modes, such as air cooling and liquid cooling, have been designed for components with large heat generation in devices such as computers and laptops. In the air cooling mode, a cooling fan is mainly used for heat dissipation of a heat-producing component. A fan rotor for the cooling fan can increase the air circulation rate while rotating, thereby improving the heat exchange efficiency with air. During operation, the cooling fan can continuously conduct the heat generated by the heat-producing components in the electronic device during operation to ambient air, thereby implementing heat dissipation.

Currently, cooling fans used in electronic devices include centrifugal fans and axial flow fans. Blades of the centrifugal fan can generate an air flow in a radial direction of the central shaft of the fan rotor, while blades of the axial flow fan can generate an air flow in an axial direction of the central shaft of the fan rotor. The two types of cooling fans have different characteristics. By combining the blades of the two types of cooling fans in the fan rotor, the air inlet volume and air pressure of the cooling fan can be improved when a specific region is cooled, thereby improving the heat dissipation capability of the cooling fan.

In practical situations, the blades with the rotor characteristics can increase the flow rate and the air pressure of the cooling fan. For the fan rotor of the cooling fan, blades with rotor characteristics may be added on the basis of centrifugal blades. In this manner, the air inlet volume of the cooling fan can be increased while ensuring the sweeping capability, so that the performance of a single cooling fan can be effectively improved, and the backflow resistance capability of the cooling fan is enhanced, thereby reducing the loss of flow entering the system by the cooling fan. The combination of the two types of blades can increase the flow rate of the cooling fan inlet system given the same size, break through the performance bottleneck of conventional centrifugal cooling fans, and improve the heat dissipation capability of the cooling fan.

When combined, the two different types of blades need to be connected into a whole. Since the two types of blades are arranged at different positions, i.e., the inner ring and the outer ring, unstable factors are increased when the two types of blades are connected into a whole. As a result, the stability of the cooling fan during operation may be affected. It will be appreciated that during operation of the cooling fan, the blades may generate noise and sway during operation due to the insufficient connection stability, thereby affecting the heat dissipation capability of the cooling fan.

To ensure stability of the cooling fan in operation, some embodiments of the present application provide a cooling fan applicable to an electronic device such as a laptop, a personal computer (PC), or the like. The fan rotor of the cooling fan is provided with different types of blades at different positions, i.e., the inner ring and the outer ring, and the blades on the inner ring can be directly connected to the central shaft of the fan rotor. The blades on the outer ring may be connected via the fixing rings arranged at both ends of the blades on the outer ring, thereby increasing the connection areas of the blades. Further, the fixing ring close to the inner ring is connected to the central shaft and/or the blades on the inner ring, so that the two types of blades are connected into a whole. By arranging the plurality of fixing rings, the connection stability between outer ring blades and between outer and inner ring blades can be improved, thereby ensuring stability of the cooling fan in operation.

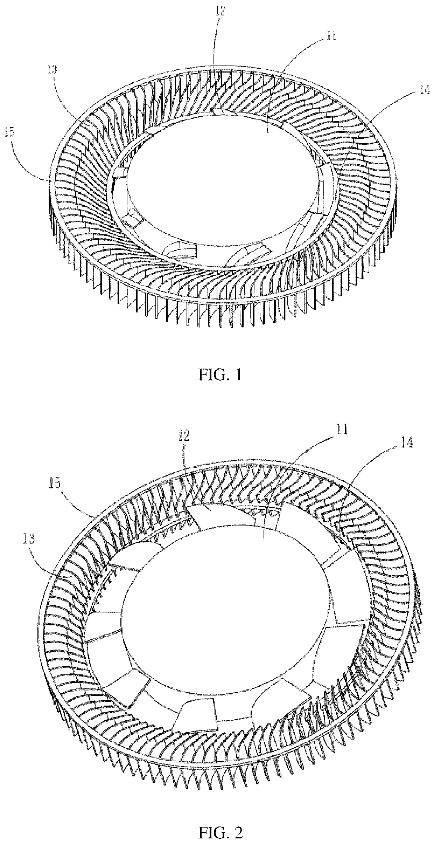

A fan rotor for a cooling fan according to some embodiments of the present application is explained below with reference to FIGs. 1 to 8.

As shown in FIGs. 1 to 4, a fan rotor according to some embodiments of the present application includes a central shaft 11, a plurality of first blades 12, a plurality of second blades 13, a first fixing ring 14, and a second fixing ring 15. The plurality of first blades 12 are arranged around the central shaft 11, with first ends connected to the central shaft 11. The plurality of second blades 13 are arranged around the central shaft 11, and located at a periphery of the plurality of first blades 12. The first fixing ring 14 is configured to fix first ends of the plurality of second blades 13, and arranged around the central shaft 11. The second fixing ring 15 is configured to fix second ends of the plurality of second blades 13, and arranged around the first fixing ring 14.

The central shaft 11 is a part of the fan rotor for fixing the blades, and may also be referred to as a disc or hub of blades, or may form a motor case. The fan rotor is matched with the fan stator, and rotated relative to the fan stator when driven by a motor. During rotation with the central shaft 11, the blades may disturb the ambient air and form an air flow, thereby facilitating heat exchange of air.

The first blades 12 are arranged at a periphery of the central shaft 11, and may be directly connected to the central shaft 11 to be fixed around the central shaft 11. The first blades 12 are blades having a first type sweeping function.

The second blades 13 extend along the periphery the first blades 12. The second blades 13 are blades having a second type sweeping function. One of the second blade 13 or the first blade 12 is a blade (centrifugal blade) used in a centrifugal fan, and the other is a blade (axial flow blade) used in an axial flow fan. To fully exert the performance of both types of blades, the blade used for the axial flow fan may be arranged on the inner ring, and the blade used for the centrifugal fan may be arranged on the outer ring. The blade adopted in the axial flow fan has an air suction capacity and can increase the air inlet volume. In practical situations, the axial flow blade has axial air suction characteristics of a rotor blade, so that air flows in an axial direction of the central shaft 11. The air inlet volume of the cooling fan can be effectively increased by the axial air suction capacity of the blade. In addition, each of the first blade 12 and the second blade 13 may follow a curve when extending from root to tip, so that the blades can be fully extended, and the air volume and air pressure can be increased.

The first fixing ring 14 disposed at the periphery of the central shaft 11 can provide a connection basis for fixing the second blade 13, so that all the second blades 13 as a whole are kept stable during operation. Therefore, noise during operation of the blades is reduced, and the fixing ring 14 may also be referred to as a silencer ring. The first fixing ring 14 may be connected to second ends of the plurality of first blades 12, or may be spaced apart from the second ends of the first blades 12. As the connection areas between the first fixing ring 14 and the inner ring blades increase, the corresponding connection strength of between different blades is also increased.

The second fixing ring 15 is disposed at a periphery of the first fixing ring 14, and may be fixed at an extended end of the second blade 13. With the combination of the first fixing ring 14 and the second fixing ring 15, fixation is provided at both the root and the tip of the second blade 13. The second blade 13 may be further connected to the central shaft 11, so that the plurality of second blades 13 and the plurality of first blades 12 are connected into a whole.

One or more first fixing ring 14 and one or more second fixing ring 15 may be provided. The first fixing ring 14 may be connected to the central shaft 11 through an added extension part at the end of the second blade 13, or through a connection part, or through a separate connector.

In the fan rotor according to some embodiments of the present application, when the second blades 12 are arranged at a periphery of the first blades 13, fixing rings may be provided at two ends of the second blades 13, respectively. In other words, the plurality of second blades 13 are connected at roots by the first fixing ring 14, and connected at tips by the second fixing ring 15. The first blades 12 are directly connected to the periphery of the central shaft 11. With the fixing rings at both ends of the blades on an outer ring, the connection areas of the blades are increased, and the two types of blades are connected into a whole. By arranging the plurality of fixing rings, the connection stability between outer ring blades and between outer and inner ring blades can be improved, thereby ensuring stability of the cooling fan in operation.

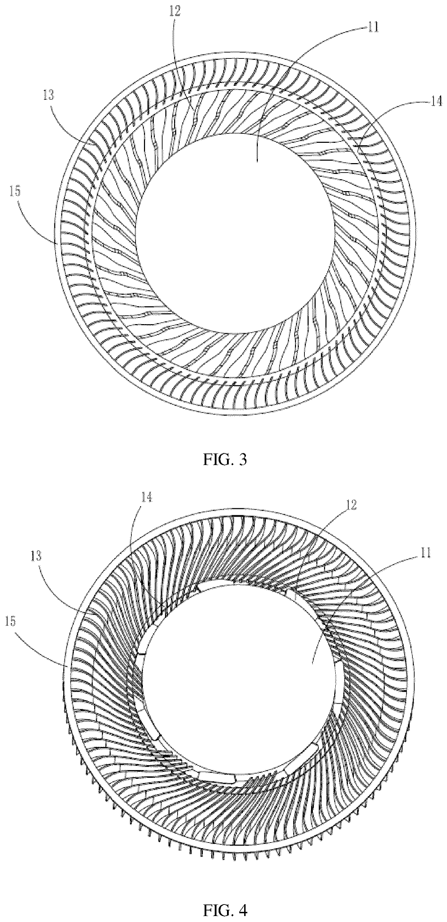

As shown in FIGs. 4 to 6, some of the plurality of second blades 13 may be provided with extension parts 131 at the first ends, and each extension part 131 passes through a gap between two adjacent first blades 12 to be connected to the central shaft 11.

When the first fixing ring 14 is not directly connected to the central shaft 11, or the connection between the first fixing ring 14 and the first blades 12 alone is insufficient to ensure the overall connection strength of the two types of blades, the first ends of some second blades 13 may be extended to be attached to the central shaft 11 and directly connected to the central shaft 11. Therefore, the first fixing ring 14 may be connected to the central shaft 11 via the extension parts 131.

By increasing the connection area between the second blade 13 and the central shaft 11, the overall connection strength of the two types of blades as a whole can be improved, and the stability of the blades in operation can be ensured.

In some embodiments, the extension parts 131 in the same gap may be connected with each other.

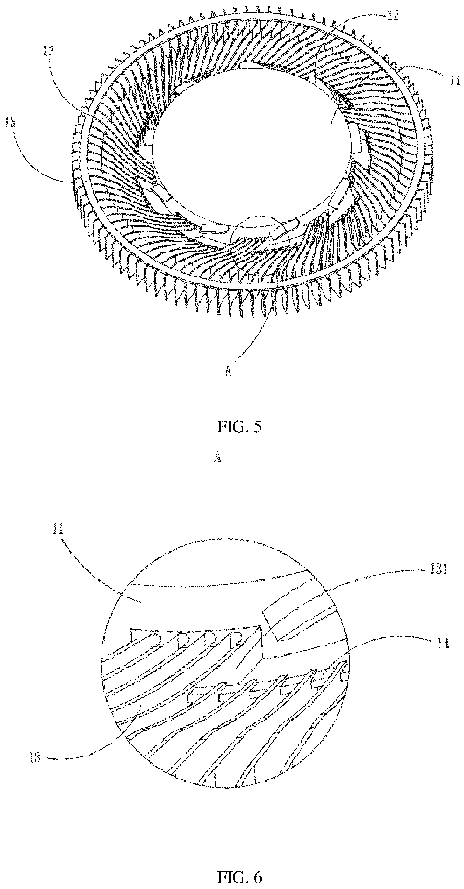

As shown in FIGs. 5 and 6, while the first end of the second blade 13 is connected to the central shaft 11 through the extension part 131, the respective extension parts 131 in the same gap may be connected with each other. In this manner, the connection area of each extension part 131 can be increased, and the overall connection strength with the central shaft 11 can be improved.

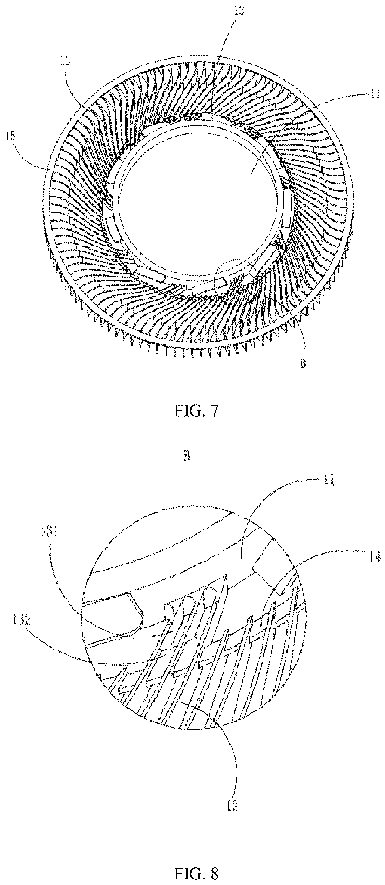

In addition, as shown in FIGs. 7 and 8, a reinforcing part 132 may be provided between two adjacent extension parts 131 connected to the central shaft 11, and extends from a surface of the first fixing ring 14 to the central shaft 11.

The reinforcing part 132 is formed on the first fixing ring 14 and connected to the central shaft 11, and two adjacent extension parts 131 independent from each other are connected with each other. In this manner, not only the connection strength between the first fixing ring 14 and some of the second blades 13 is improved, but also the connection strength of the some second blades 13 as a whole is improved.

In some embodiments, the first fixing ring 14 may be connected to the plurality of second blades 13 at edges of the second blades 13 in an axial direction of the central shaft 11, and/or the second fixing ring 15 may be connected to the plurality of second blades 13 at edges of the second blades 13 in the axial direction of the central shaft 11.

In other words, the fixing rings may be formed at edges of the second blades 13 in the axial direction of the central shaft 11. By providing the connection areas at the edges, the connection between the fixing rings and the second blades 13 can be facilitated, and the fitting structures for connection between the fixing rings and the second blades 13 can be simplified. In practical situations, the fixing rings may be attached to the plurality of second blades 13.

In some embodiments, the first fixing ring 14 may be connected to the plurality of first blades 12 at middle parts of the first blades 12 in an axial direction of the central shaft 11, and/or the second fixing ring 15 may be connected to the plurality of second blades 13 at middle parts of the second blades 13 in the axial direction of the central shaft 11.

In other words, the fixing rings may be formed at middle parts of the second blades 13 in the axial direction of the central shaft 11, so that the fixing rings are spaced apart by a certain distance from edges of the second blades 13 in the axial direction of the central shaft 11. In practical situations, the fixing rings may be partially or entirely snapped into a plurality of second blades 13 in the radial direction of the central shaft 11.

In practical situations, as shown in FIG. 1, both the first fixing ring 14 and the second fixing ring 15 may be attached to surfaces of the plurality of second blades 13. Alternatively, different fixing rings may be connected to the plurality of second blades 13 in different manners. In other words, one of the first fixing ring 14 or the second fixing ring 15 may be formed on the surfaces of the plurality of second blades 13, and the other may be snapped into the plurality of second blades 13. As shown in FIG. 2, the first fixing ring 14 may be snapped into the plurality of second blades 13, and the second fixing ring 15 may be formed on the surfaces of the plurality of second blades 13. Alternatively, both the first fixing ring 14 and the second fixing ring 15 may be snapped into the plurality of second blades 13.

In some embodiments, the plurality of first blades 12 may be axial flow blades, and the plurality of second blades 13 may be centrifugal blades.

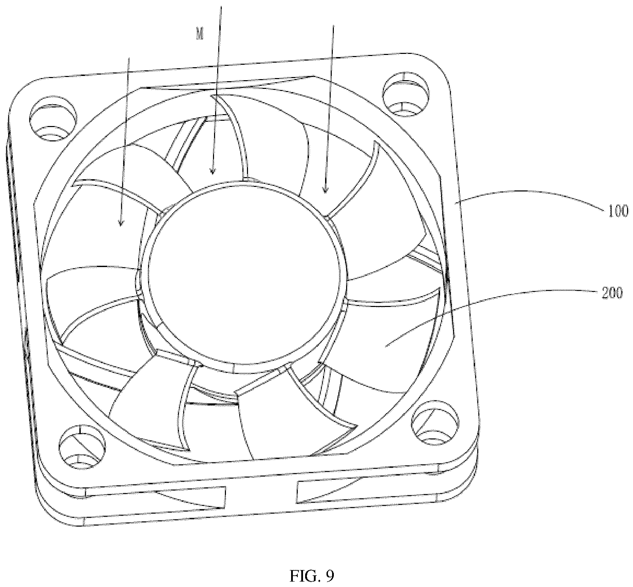

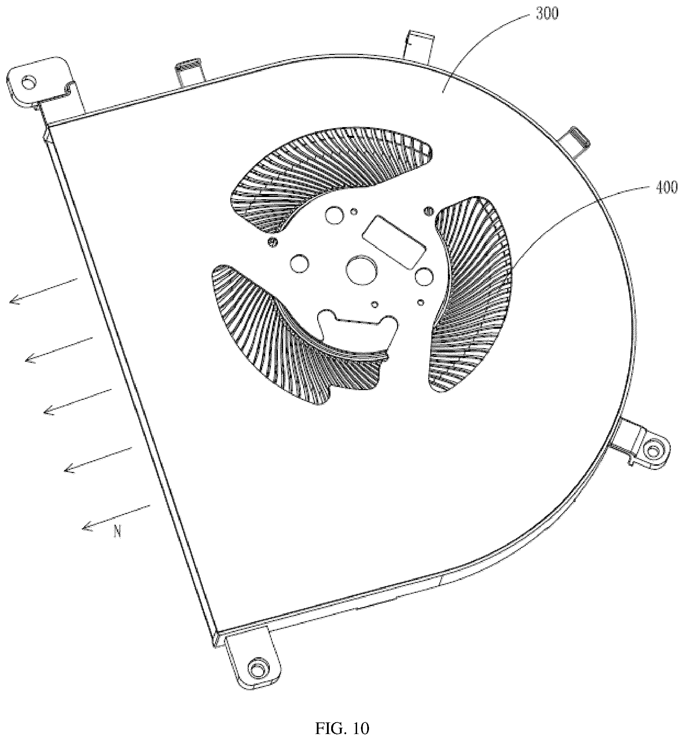

Axial flow blades 200 used in an axial flow fan 100 as shown in FIG. 9 are arranged on the inner ring, and centrifugal blades 400 used in a centrifugal fan 300 as shown in FIG. 10 are arranged on the outer ring, so that both types of blades can exhibit excellent performance. The axial flow blades 200 used in the axial flow fan 100 have an air suction capacity and can increase the air inlet volume. During rotation, the axial flow blades 200 generate an air flow in an axial direction indicated by the arrow M in FIG. 9. The axial flow blades 200 each have a forward or backward inclined shape and a larger effective area in the axial direction, and can generate an air flow in the axial direction during rotation. Generally, fewer axial flow blades 200 are provided, and a single axial flow blade 200 may take a large area when arranged. In contrast, the centrifugal fan 300 may be provided with more centrifugal blades 400, which have a larger effective area in the radial direction and may be rotated to generate an air flow in a radial direction indicated by the arrow N in FIG. 10. The centrifugal blades can play a better role in sweeping air at a periphery.

It should be noted that in the embodiments of the present application, the case where the first blade 12 may be an axial flow blade, and the second blade 13 may be a centrifugal blade is taken as an example for illustration. The plurality of first blades 12 may be centrifugal blades, and the plurality of second blades 13 may be axial flow blades, which are not limited in the present application.

In some embodiments, the plurality of first blades 12 may be arranged inclined, or the plurality of first blades 12 may be arranged curved.

The inclined or curved first blades 12 can facilitate air suction of the cooling fan in the axial direction. When the first blade 12 is inclined or curved with respect to the second blade 13, an air suction characteristic similar to that of a rotor blade may be formed, so that a pressure difference is formed across two sides of the central shaft 11, and the air inlet volume is increased.

In practical situations, the inclined blade can facilitate convenient manufacturing and molding, while the curved blade can enhance the air suction capacity. The inclined blade may be a straight-plate blade, which means that the blade has a planar shape as a whole, and is inclined with respect to the second blade 13 as a whole. The curved blade may adopt a curved blade with a bigger tip and a smaller root, or a curved blade with a smaller tip and a bigger root. In addition, the first blade 12 may be designed to have different degrees of curvature to adjust the air suction capacity.

It should be further noted that in the embodiments of the present application, the shape and number of the axial flow blades are not limited, and any blade that can achieve the basic function of an axial flow blade is within the scope of the present application. Similarly, in the embodiments of the present application, the shape and number of the centrifugal blades are not limited, and any blade that can achieve the basic function of a centrifugal blade is within the scope of the present application.

In some embodiments, in an axial direction of the central shaft 11, surfaces of the first blades 12 may not protrude from surfaces of the second blades 13.

In other words, when the fan rotor is formed, a surface of the first blade 12 is flush with a surface of the second blade 13, or a surface of the first blade 12 in the axial direction of the central shaft 11 is lower than the surface of the second blade 13. Therefore, the first blade 12 will not occupy more space, which is beneficial to overall miniaturization of the cooling fan.

In practical situations, the plurality of second blades 13 and the plurality of first blades 12 may be distributed in different planes, and in the axial direction of the central shaft 11, it is also possible that each first blade 12 at least partially protrudes from an edge of the second blade 13.

The first blade 12 is arranged at an air inlet of the fan rotor, so that the first blade 12 may be distributed in a different plane from the second blade 13, and extend beyond edges of the second blade 13 at the air inlet side. Therefore, the effective area of the first blade 14 is increased to form an air flow in the axial direction in a larger region, thereby increasing the air inlet volume of the fan rotor.

In addition, the plurality of first blades 12 may be distributed uniformly at the periphery of the central shaft 11, and/or the plurality of second blades 13 may be distributed uniformly at the periphery of the central shaft 11.

The first blades 12 and the second blades 13 uniformly arranged can generate a uniform air flow guidance effect at the periphery of the central shaft 11 and relatively uniform stress on the blades, so that the operation process of the fan rotor is more stable.

In some embodiments, the plurality of first blades 12, the plurality of second blades 13, the first fixing ring 14, and the second fixing ring 15 may be integrally formed with the central shaft 11.

Therefore, the connection strength between the structures can be effectively improved. Since the first blade 12 and the second blade 13 are blades of different shapes and sizes, connection failure of the blades may easily occur in the manufacturing process due to different manufacturing processes. With the first blade 12 and the second blade 13 combined by integrally forming, the connection strength of the combined blades can be ensured. In addition, the fixing ring 12 may also be integrally formed with the central shaft 11 and the blades.

Some embodiments of the present application further provide a cooling fan, including a housing, a fan stator, and the fan rotor as described above. The fan stator is disposed in the housing, and the fan rotor is rotatably connected to the fan stator.

The cooling fan with the combined blades allows to integrate the respective characteristics of the centrifugal blade and the rotator blade like an axial flow blade. By means of the characteristics of the air suction blades, the air volume and air pressure of the cooling fan can be significantly improved. Further, by optimizing flow channels in the cooling fan, a small part of air flow can be guided into some regions with concentrated heat sources for heat dissipation, so that the heat dissipation capability and performance of the whole system are improved.

In addition, the blades on the outer ring may be connected via the fixing rings arranged at both ends of the blades on the outer ring, so that the connection areas of the blades are increased. Further, the fixing ring close to the inner ring is connected to the central shaft and/or the blades on the inner ring, so that the two types of blades are connected into a whole. By arranging the plurality of fixing rings, the connection stability between outer ring blades and between outer and inner ring blades can be improved, thereby ensuring stability of the cooling fan in operation.

Some embodiments of the present application further provide an electronic device, including the cooling fan as described above.

The cooling fan may be used in the electronic device at a position corresponding to a component generating a large amount of heat. Based on the characteristics of the different types of blades, the air inlet volume at the air inlet of the cooling fan can be increased, and the air volume and air pressure at the air outlet can be effectively increased. Therefore, the problem of inadequate system air volume in an electronic device such as an ultra-thin laptop can be addressed. In addition, stability of the cooling fan in operation can be ensured by the multiple fixation, thereby ensuring the heat dissipation capability of the cooling fan.

It will be understood by those of ordinary skill in the art that the foregoing implementations are specific embodiments of the present application, and that, in practical applications, various changes in form and details may be made therein without departing from the spirit and scope of the present application.

## Claims

1. A fan rotor, comprising:
a central shaft;
a plurality of first blades arranged about the central shaft, with first ends connected to the central shaft;
a plurality of second blades arranged about the central shaft and located at a periphery of the plurality of first blades;
a first fixing ring configured to fix first ends of the plurality of second blades and arranged around the central shaft. and
a second fixing ring configured to fix second ends of the plurality of second blades and arranged around the first fixing ring.

2. The fan rotor of claim 1, wherein:
some of the plurality of second blades are provided with extension parts at the first ends, and each extension part passes through a gap between two adjacent first blades to be connected to the central shaft.

3. The fan rotor of claim 2, wherein:
the extension parts in the same gap are connected with each other.

4. The fan rotor of claim 2, wherein:
a reinforcing part is provided between two adjacent extension parts connected to the central shaft, and extends from a surface of the first fixing ring to the central shaft.

5. The fan rotor of claim 1, wherein:
the first fixing ring is connected to the plurality of second blades at edges of the second blades in an axial direction of the central shaft, and/or the second fixing ring is connected to the plurality of second blades at edges of the second blades in the axial direction of the central shaft.

6. The fan rotor of claim 1, wherein:
the first fixing ring is connected to the plurality of second blades at middle parts of the second blades in an axial direction of the central shaft, and/or the second fixing ring is connected to the plurality of second blades at middle parts of the second blades in the axial direction of the central shaft.

7. The fan rotor of any one of claims 1 to 6, wherein:
the plurality of first blades are axial flow blades, and the plurality of second blades are centrifugal blades.

8. The fan rotor of claim 1, wherein:
in an axial direction of the central shaft, surfaces of the first blades do not protrude from surfaces of the second blades.

9. A cooling fan, comprising:
a housing,
a fan stator in the housing; and
the fan rotor of any of claims 1 to 8, wherein the fan rotor is rotatably connected to the fan stator.

10. An electronic device, comprising the cooling fan of claim 9.
